# EUROPEAN PATENT APPLICATION

(11) **EP 4 718 504 A1**
(43) Date of publication of application: **01.04.2026**
(21) Application number: 23939310.1
(22) Date of filing: 29.11.2023
(51) Int. Cl.: H01L 31/18, H01L 31/074

(54) **METHOD FOR MANUFACTURING SOLAR CELL**

(30) Priority: 31.05.2023 CN 202310633987
(71) Applicant: Ja Solar Technology Yangzhou Co., Ltd., Yangzhou, Jiangsu 225131 (CN)
(72) Inventor: ZHANG, Junbing, Yangzhou, Jiangsu 225131 (CN); CHEN, Bin, Yangzhou, Jiangsu 225131 (CN); YIN, Haipeng, Yangzhou, Jiangsu 225131 (CN)
(74) Representative: Sun, Yiming
(86) International application number: PCT/CN2023/135026
(87) International publication number: WO 2024/244341

(57) **Abstract**

Provided is a method for manufacturing a solar cell, comprising: providing a silicon substrate of a first conductivity type, and performing double-sided polishing on the silicon substrate; performing gettering treatment on the silicon substrate, comprising placing the silicon substrate in a gettering source to form a first silicon doped layer and a first silicon glass layer on a first surface of the silicon substrate and form a second silicon doped layer and a second silicon glass layer on a second surface of the silicon substrate opposite to the first surface; removing the first silicon glass layer; after the first silicon glass layer is removed, texturing the first surface of the silicon substrate, and removing the first silicon doped layer at the same time to form a textured surface on the first surface of the silicon substrate; removing at least a part of the second silicon glass layer and the second silicon doped layer; and smoothing the first surface of the silicon substrate.

## Description

This application claims the priority of China patent application No.202310633987.X, titled "Manufacturing method of solar cell", and filed on May 31, 2023, and the disclosure of this China patent application is hereby incorporated in its entirety as a part of the present application.

### TECHNICAL FIELD

The present disclosure relate to a manufacturing method of a solar cell.

### BACKGROUND

Silicon-based heterojunction (HJT) battery is a kind of semiconductor device that can convert solar energy into electric power output. In general, n-type silicon substrate is used to prepare heterojunction batteries. The preparation process of a heterojunction battery may include: providing a silicon substrate; depositing an intrinsic α-Si:H layer at each of the front side and back side of the n-type silicon substrate; then respectively forming a p-type α-Si:H layer and an n-type α-Si:H layer on the intrinsic α-Si:H layers at the front side and back side; finally, forming an electrode by screen printing, drying and curing with a low-temperature silver paste. In practical production, transparent conductive oxide films (TCO) can be deposited on the p-type α-Si:H layer and the n-type α-Si:H layer respectively, and then metal electrodes can be formed.

With respect to the heterojunction battery, it has better surface passivation effect, so the material properties of silicon substrate itself have greater influence on the efficiency of batteries. There are technical solutions in the industry to improve the performance of silicon substrate and improve the filling factor and battery efficiency by gettering process, but the specific gettering steps and preparation process of heterojunction batteries still need to be adjusted and improved.

### SUMMARY

At least some embodiments of the present disclosure provide a manufacturing method of a solar cell, which includes: providing a silicon substrate of a first conductivity type, and double-side polishing the silicon substrate; performing a gettering treatment on the silicon substrate, including: placing the silicon substrate in a gettering source to form a first silicon doped layer and a first silicon glass layer on a first surface of the silicon substrate and a second silicon doped layer and a second silicon glass layer on a second surface of the silicon substrate opposite to the first surface; removing the first silicon glass layer; removing the first silicon glass layer, texturing the first surface of the silicon substrate, removing the first silicon doped layer, and simultaneously forming a textured surface on the first surface of the silicon substrate; and removing at least a part of the second silicon glass layer and the second silicon doped layer.

For example, in some embodiments, in a step of removing the second silicon doped layer, only a part of the second silicon doped layer is removed, the first silicon dope layer and the second silicon doped layer are of the first conductivity type.

For example, in some embodiments, a thickness of the remaining second silicon doped layer after the removing is less than 500nm.

For example, in some embodiments, the manufacturing method further includes: respectively forming a first intrinsic silicon-containing layer and a second intrinsic silicon-containing layer at a side of the first surface and a side of the second surface of the silicon substrate; respectively forming a first doped silicon-containing layer of a second conductivity type and a second doped silicon-containing layer of a first conductivity type on the first intrinsic silicon-containing layer and the second intrinsic silicon-containing layer, the second conductivity type is different from the first conductivity type; and respectively forming a first transparent conductive layer and a second transparent conductive layer on the first doped silicon-containing layer and the second doped silicon-containing layer.

For example, in some embodiments, the first doped silicon-containing layer of the second conductivity type and the second doped silicon-containing layer of the first conductivity type are a p-doped silicon-containing layer and an n-doped silicon-containing layer, respectively.

For example, in some embodiments, the first doped silicon-containing layer of the second conductivity type and the second doped silicon-containing layer of the first conductivity type are an n-type doped silicon-containing layer and a p-type doped silicon-containing layer, respectively.

For example, in some embodiments, the manufacturing method further includes: after texturing the first surface of the silicon substrate and before forming the first intrinsic silicon-containing layer at the side of the first surface of the silicon substrate, rounding the first surface of the silicon substrate.

For example, in some embodiments, the manufacturing method further including: respectively forming a first transparent conductive layer and a second transparent conductive layer on the first doped silicon-containing layer and the second doped silicon-containing layer; and respectively forming a first metal electrode and a second metal electrode on the first transparent conductive layer and the second transparent conductive layer.

For example, in some embodiments, the first transparent conductive layer is a single layer or a stacked layer made of a material selected from the group consisting of metal oxides doped with a doping element, metal nitrides doped with a doping element, and mixtures thereof. The doping element includes at least one selected from the group consisting of indium, tin, calcium, aluminum, cadmium, zinc, cerium and fluorine. The metal oxides include indium oxide, tin oxide, zinc oxide, cadmium oxide, and titanium nitride. The metal nitrides include titanium nitride.

For example, in some embodiments, the second transparent conductive layer is a single layer or a stacked layer made of a material selected from the group consisting of metal oxides doped with a doping element, metal nitrides doped with a doping element, and mixtures thereof. The doping element includes at least one selected from the group consisting of indium, tin, calcium, aluminum, cadmium, zinc, cerium and fluorine. The metal oxides include indium oxide, tin oxide, zinc oxide, cadmium oxide, and titanium nitride. The metal nitrides include titanium nitride.

For example, in some embodiments, a thickness of the first transparent conductive layer is in a range of 1-100 nm, and a thickness of the second transparent conductive layer is in a range of 1-100 nm.

For example, in some embodiments, the first intrinsic silicon-containing layer is a single layer or a stacked layer made of a material selected from the group consisting of microcrystalline silicon, nano silicon, amorphous silicon, silicon oxide, silicon carbide and mixtures thereof. A thickness of the first intrinsic silicon-containing layer is in a range of 1-50nm.

For example, in some embodiments, the second intrinsic silicon-containing layer is a single layer or a stacked layer made of a material selected from the group consisting of microcrystalline silicon, nano silicon, amorphous silicon, silicon oxide, silicon carbide and mixtures thereof. A thickness of the second intrinsic silicon-containing layer is in a range of 1-50 nm.

For example, in some embodiments, the first doped silicon-containing layer is a single layer or a stacked layer made of a material selected from the group consisting of microcrystalline silicon, nano silicon, amorphous silicon, silicon oxide, silicon carbide and mixtures thereof. A thickness of the first doped silicon-containing layer is in a range of 1-50 nm.

For example, in some embodiments, the second doped silicon-containing layer is a single layer or a stacked layer made of a material selected from selected from the group consisting of microcrystalline silicon, nano silicon, amorphous silicon, silicon oxide, silicon carbide and mixtures thereof,. A thickness of the second doped silicon-containing layer ranges from 1-50 nm.

### BRIEF DESCRIPTION OF DRAWINGS

Fig. 1 shows a flowchart of a manufacturing method of a solar cell according to an embodiment of the present disclosure;
Figs. 2A- 2I show structural diagrams corresponding to steps in a manufacturing method of a solar cell according to an embodiment of the present disclosure; and
Figs. 3A- 3E show structural diagrams corresponding to steps in a manufacturing method of a solar cell according to another embodiment of the present disclosure.

### DETAILED DESCRIPTION

Hereinafter, a solar cell and a manufacturing method thereof according to the embodiments of the present disclosure will be described in detail with reference to the drawings.

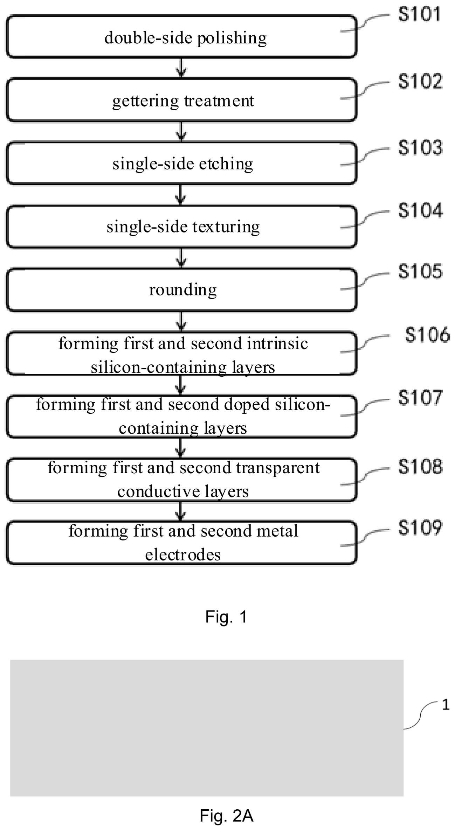

Fig. 1 shows a flowchart of a manufacturing method of a solar cell according to an embodiment of the present disclosure.

As illustrated by Fig. 1, the manufacturing method of a heterojunction solar cell according to an embodiment of the present disclosure includes:
Step S101, providing a silicon substrate of a first conductivity type, and double-side polishing the silicon substrate. The silicon substrate is a p-type silicon substrate or an n-type silicon substrate.
Step S102, performing a gettering treatment on the silicon substrate. The gettering treatment includes: placing the silicon substrate in a gettering source to form a first silicon doped layer and a first silicon glass layer on a first surface of the silicon substrate and a second silicon doped layer and a second silicon glass layer on a second surface of the silicon substrate opposite to the first surface. The first surface may be at a front side of the silicon substrate, that is, a light receiving surface of the solar cell. The second surface may be at a back side of the silicon substrate opposite to the front side. The solar cell can be a single-side solar cell that converts light energy into electric energy at one side or a double-side solar cell that converts light energy into electric energy at two sides. The present disclosure is not limited thereto. The gettering treatment may be a P (phosphorus) doping treatment or a B (boron) doping treatment.
Step S103, single-side etching, which includes: removing the first silicon glass layer.
Step S104, single-side texturing, which includes texturing the first surface of the silicon substrate, removing the first silicon doped layer, and forming a textured surface on the first surface.
Step S105: rounding, which includes: removing the second silicon glass layer and at least a part of the second silicon doped layer, and rounding the first surface of the silicon substrate.
Step S106, respectively forming a first intrinsic silicon-containing layer and a second intrinsic silicon-containing layer at the front side and the back side of the silicon substrate.
Step S107, respectively forming a first doped silicon-containing layer of a second conductivity type and a second doped silicon-containing layer of the first conductivity type on the first intrinsic silicon-containing layer and the second intrinsic silicon-containing layer, the second conductivity type being different from the first conductivity type; the first conductivity type may be n-type and the second conductivity type may be p-type. In other embodiments, the first conductivity type may be p-type and the second conductivity type may be n-type.
Step S108, respectively forming a first transparent conductive layer and a second transparent conductive layer on the first doped silicon-containing layer and the second doped silicon-containing layer.
Step S109, respectively forming a first metal electrode and a second metal electrode on the first transparent conductive layer and the second transparent conductive layer.

The manufacturing steps in step S106 and step S109 may be performed in parallel or in other order, and the present disclosure is not limited thereto.

In step S105, only a part or all of the second silicon doped layer may be removed. When only a part of the second silicon doped layer is removed, the second silicon doped layer is preferably of the first conductivity type. For example, when the silicon substrate is an n-type silicon substrate, the gettering treatment is phosphorus doping treatment to form an n-type second silicon doped layer, or when the silicon substrate is a p-type silicon substrate, the gettering treatment is boron doping treatment to form a p-type second silicon doped layer. When the second silicon doped layer is completely removed, the gettering treatment is phosphorus doping treatment or boron doping treatment, which is not limited by the type of silicon substrate.

In step S106, each of the first intrinsic silicon-containing layer and the second intrinsic silicon-containing layer may be a single layer or a stacked layer made of a material selected from the group consisting of microcrystalline silicon, nano-silicon, amorphous silicon, silicon oxide, silicon carbide and mixtures thereof. The thickness of the first intrinsic silicon-containing layer may be in the range of 1-50 nm. The thickness of the second intrinsic silicon-containing layer may be in the range of 1-50 nm.

In step S108, each of the first doped silicon-containing layer and the second doped silicon-containing layer may be a single layer or a stacked layer made of a material selected from the group consisting of microcrystalline silicon, nano-silicon, amorphous silicon, silicon oxide, silicon carbide and mixtures thereof. The thickness of the first doped silicon-containing layer may be in a range of 1-50 nm. The thickness of the second doped silicon-containing layer may be in a range of 1-50 nm.

In step S109, each of the first transparent conductive layer and the second transparent conductive layer may be a single layer or a stacked layer made of a material selected from the group consisting of metal oxides doped with a doping element and metal nitrides doped with a doping element and mixtures thereof. The doping element may include at least one selected from the group consisting of indium, tin, calcium, aluminum, cadmium, zinc, cerium and fluorine. The metal oxides include indium oxide, tin oxide, zinc oxide, cadmium oxide and titanium nitride. The metal nitrides include titanium nitride. The thickness of the first transparent conductive layer may be in the range of 1-100 nm. The thickness of the second transparent conductive layer may be in the range of 1-100 nm.

In the manufacturing method of a solar cell according to the embodiment of the present disclosure, the substrate is subjected to double-side polishing treatment before gettering treatment. Therefore, a large number of cutting defects on the surface of raw silicon substrate can be removed, thus improving the effect of gettering treatment.

A manufacturing method of a solar cell includes: double-side polishing a silicon substrate; double-side texturing the silicon substrate; and then performing gettering treatment; removing the silicon glass layer formed at the back side of the silicon substrate in the gettering treatment; and polishing the back side of the silicon substrate.

Another manufacturing method of a solar cell includes: double-side polishing the silicon substrate; forming a mask layer at the back side of the silicon substrate; performing single-side texturing treatment on the silicon substrate; then performing gettering treatment; and removing the silicon glass layer formed at the back side of the silicon substrate in the gettering treatment.

In the manufacturing method of the solar cell according to the embodiment of the present disclosure, the conventional and complete surface treatment and texturing step of the silicon substrate including polishing and texturing is divided, and the silicon substrate is textured at a single side after gettering treatment. Therefore, the second silicon glass layer (e.g., phosphosilicate glass layer or borosilicate glass layer) formed in the gettering process can be used as a mask to prevent the second surface of the silicon substrate from being textured. Compared with the case in which the double-side texturing treatment is carried out first and then gettering treatment and polishing are carried out, this method eliminates one step of texturing and one step of polishing, and reduces the amount of textured and polished substrate, that is, reduces the reduced weight of silicon substrate, which is beneficial to the advancement of silicon wafer thinning. Compared with the case in which the single-side texturing treatment is carried out first and then the gettering treatment is carried out, the mask step in the single-side texturing step is omitted. Therefore, the manufacturing method of a solar cell can be simplified by single-side texturing the silicon substrate after the gettering treatment. In addition, performing single-side texturing treatment of silicon substrate after the gettering treatment can save chemical consumption and cost.

According to the manufacturing method of the solar cell in the embodiment of the present disclosure, the order of each manufacturing step is reasonably arranged, so that the usage amount of equipment is saved, thereby saving the cost and the occupied area. For example, the second silicon glass layer and at least a part of the second silicon doped layer on the second surface of the silicon substrate can be removed at the same time of the rounding processing.

The solar cell prepared by the manufacturing method of a solar cell according to the embodiment of the present disclosure includes a polished surface at the back side, so it is beneficial to improving the utilization rate of light, increasing the current, improving the passivation performance and improve the battery efficiency.

Figs. 2A-2H show structural diagrams corresponding to steps in a manufacturing method of a solar cell according to an embodiment of the present disclosure.

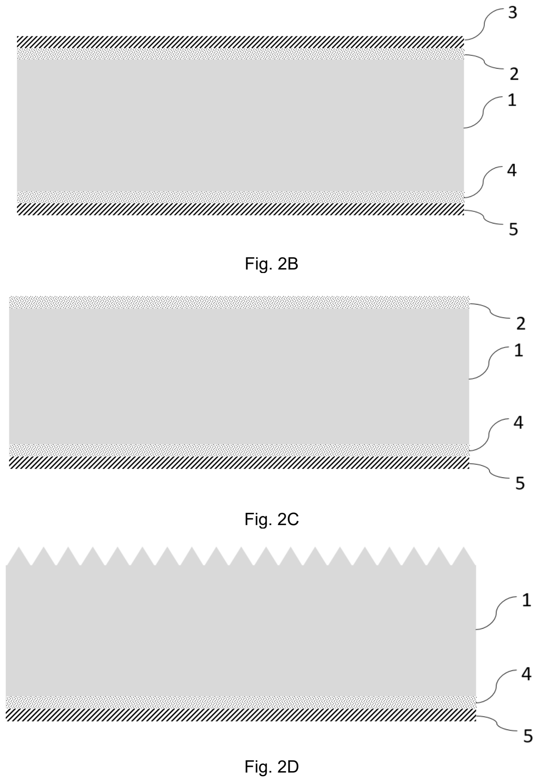

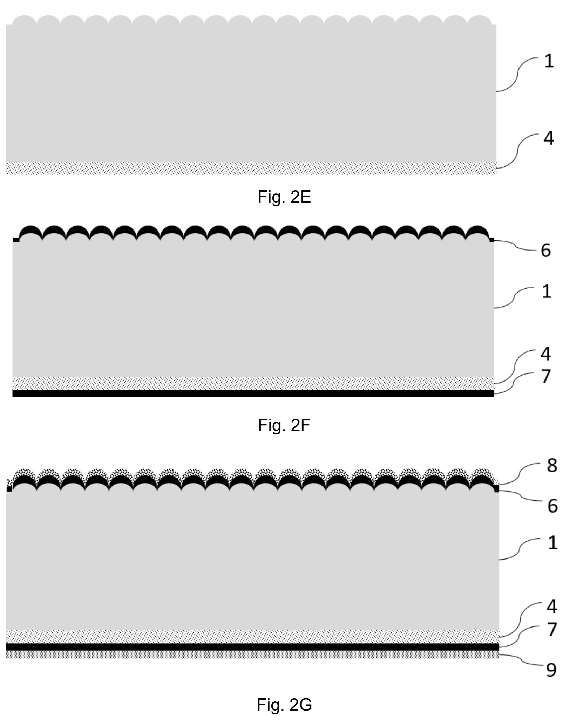

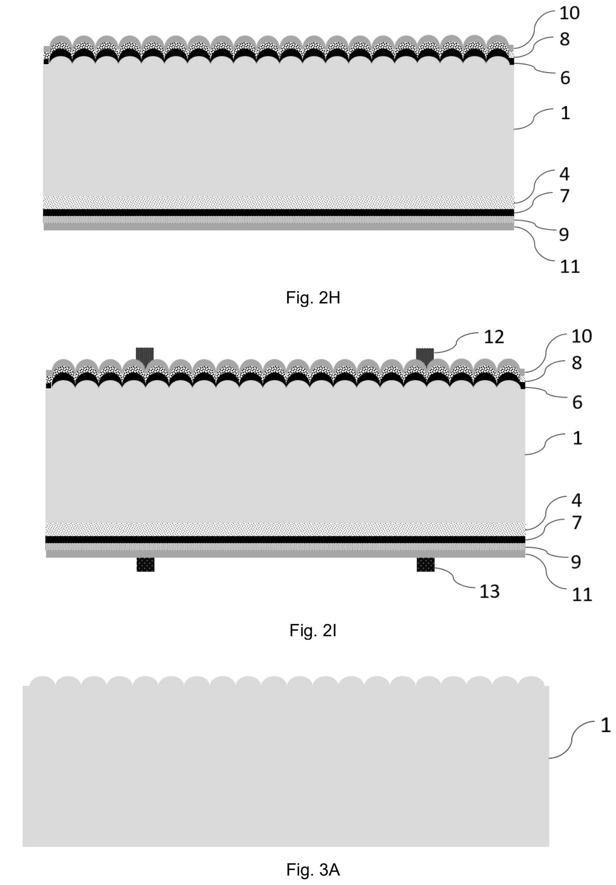

As illustrated by Figs. 2A-2H, the manufacturing method of the heterojunction solar cell according to an embodiment of the present disclosure includes:
Step S201, providing an n-type silicon substrate 1, and double-sided polishing the silicon substrate 1, as illustrated by Fig. 2A.
Step S202, performing a phosphorus doping gettering treatment on the silicon substrate 1, as illustrated by Fig. 2B. After the gettering treatment, a first n-type silicon doped layer as the first silicon doped layer 2 and a first phosphosilicate glass layer as the first silicon glass layer 3 are formed on a first surface at the front side of the silicon substrate 1, and a second n-type silicon doped layer as the second silicon doped layer 4 and a second phosphosilicate glass layer as the second silicon glass layer 5 are formed on a second surface at the back side of the silicon substrate 1. The gettering treatment includes: placing the silicon substrate 1 in a gettering source containing doping atoms at a specific temperature to form the first silicon doped layer 2 and the second silicon doped layer 4 by diffusing the doping atoms into the first surface and the second surface of the silicon substrate 1, respectively. Meanwhile, the first silicon glass layer 3 and the second silicon glass layer 5 are respectively formed on the surfaces of the first silicon doped layer 2 and the second silicon doped layer 4 facing away from the silicon substrate 1.
Step S203, single-side etching, which includes: removing the first silicon glass layer 3, as illustrated by Fig. 2C. For example, the side of the first surface of the silicon substrate 1 is wet etched by HF solution to remove the first silicon glass layer 3.
Step S204, single-side texturing, which includes: texturing the first surface of the silicon substrate 1 to form a textured surface on the first surface, simultaneously removing the first silicon doped layer 2, as illustrated by Fig. 2D. For example, the first surface of the silicon substrate 1 is textured by KOH or NaOH solution.
Step S205: rounding, which includes: removing a part of the second silicon glass layer 5 and the second silicon doped layer 4, and simultaneously rounding the first surface of the silicon substrate 1, as illustrated by Fig. 2E. For example, a part of the second silicon glass layer 5 and the second silicon doped layer 4 is removed by a mixed solution of HNO3 and HF, and a pyramid structure formed by texturing is simultaneously rounded. Alternatively, in other embodiments, the second silicon glass layer 5 may be removed first, and then the second silicon doped layer 4 may be removed and rounded. For example, the second silicon glass layer 5 is removed by HF solution first, and then the pyramid structure formed by texturing is rounded by a mixed solution of HNO3 and HF, and at the same time, a part of the second silicon doped layer 4 is removed.
Step S206, forming a first intrinsic silicon-containing layer 6 on the first surface of the silicon substrate 1, and forming a second intrinsic silicon-containing layer 7 on the second silicon doped layer 4, as illustrated by Fig. 2F. For example, the intrinsic hydrogenated amorphous silicon layers, which respectively serve as the first intrinsic silicon-containing layer 6 and the second intrinsic silicon-containing layer 7, are formed by a plasma enhanced chemical vapor deposition (PECVD) process.
Step S207: forming a p-doped first doped silicon-containing layer 8 on the first intrinsic silicon-containing layer 6, and forming an n-doped second doped silicon-containing layer 9 on the second intrinsic silicon-containing layer 7, as illustrated by Fig. 2G. For example, the first doped silicon-containing layer 8 and the second doped silicon-containing layer 9 are formed by a PECVD process, respectively.
Step S208: respectively forming a first transparent conductive layer 10 and a second transparent conductive layer 11 on the first doped silicon-containing layer 8 and the second doped silicon-containing layer 9, as illustrated by Fig. 2H. For example, transparent conductive layers of indium tin oxide ITO (In2O3: Sn) are formed on the first doped silicon-containing layer 8 and the second doped silicon-containing layer 9 by magnetron sputtering physical vapor deposition (PVD) process, respectively.
Step S209, respectively forming a first metal electrode 12 and a second metal electrode 13 on the first transparent conductive layer 10 and the second transparent conductive layer 11, as illustrated by Fig. 2I. For example, the first metal electrode 12 and the second metal electrode 13 are formed by screen printing, respectively.

In the embodiment of the present disclosure, the removal amount of the second silicon doped layer 4 can be controlled by controlling reaction conditions such as time in the rounding step. The thickness of the remaining second silicon doped layer 4 is, for example, less than 500 nm. Because a part of the second silicon doped layer 4 with a high doping concentration is removed, a part of the second silicon doped layer 4 with a low doping concentration remains. It not only ensures the passivation degree of the silicon substrate 1, but also facilitates the lateral transmission of the silicon substrate 1. Therefore, the surface load of the silicon substrate 1 is reduced, which is beneficial to improving the collection rate of carriers.

Figs. 3A-3E show structural diagrams corresponding to steps in a manufacturing method of a solar cell according to another embodiment of the present disclosure. This embodiment is different from the embodiment shown in Figs. 2A-2H in that in the step of removing the second silicon doped layer 4, all the second silicon doped layer 4 is removed.

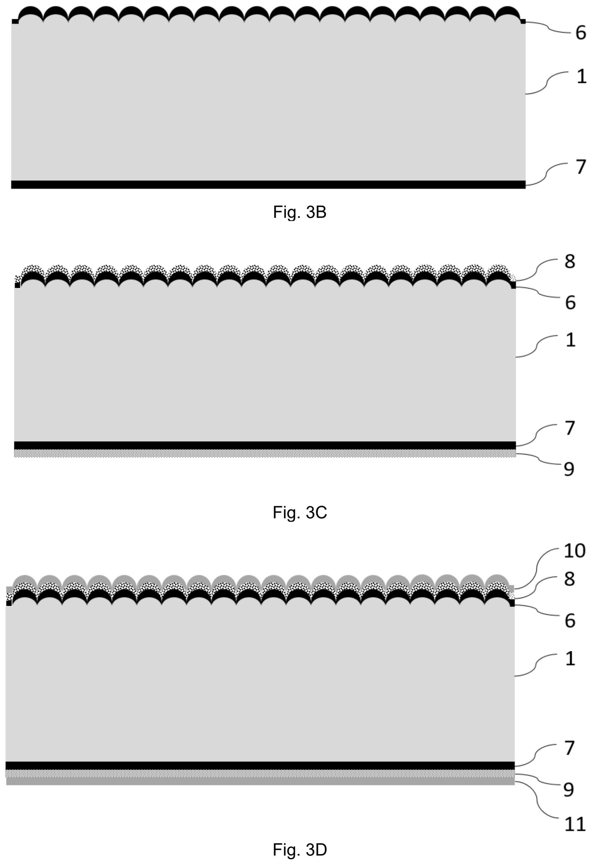

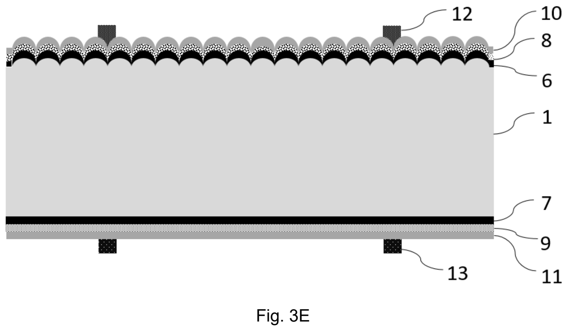

As illustrated by Figs. 3A-3E, the manufacturing method of a heterojunction solar cell according to another embodiment of the present disclosure includes:
Step S301, providing an n-type silicon substrate 1, and double-side polishing the silicon substrate 1.
Step S302, performing a phosphorus doping gettering treatment on the silicon substrate 1 to form a first n-type silicon doped layer as the first silicon doped layer 2 and a first phosphosilicate glass layer as the first silicon glass layer 3 on a first surface at a front side of the silicon substrate 1, and a second n-type silicon doped layer as the second silicon doped layer 4 and form a second phosphosilicate glass layer as the second silicon glass layer 5 on a second surface at a back side of the silicon substrate 1.
Step S303: single-side etching, which includes: removing the first silicon glass layer 3.
Step S304: single-side texturing, which includes: texturing the first surface of the silicon substrate 1 to form a textured surface on the first surface, and removing the first silicon doped layer 2.
Step S305: rounding, which includes: removing the second silicon glass layer 5 and all the second silicon doped layer 4, and simultaneously rounding the first surface of the silicon substrate 1, as illustrated by Fig. 3A.
Step S306, forming a first intrinsic silicon-containing layer 6 on the first surface of the silicon substrate 1, and forming a second intrinsic silicon-containing layer 7 on the second surface of the silicon substrate 1, as illustrated by Fig. 3B.
Step S307: forming a p-type doped first silicon-containing layer 8 on the first intrinsic silicon-containing layer 6, and forming an n-type doped second silicon-containing layer 9 on the second intrinsic silicon-containing layer 7, as illustrated by Fig. 3C.
Step S308, respectively forming a first transparent conductive layer 10 and a second transparent conductive layer 11 on the first doped silicon-containing layer 8 and the second doped silicon-containing layer 9, as illustrated by Fig. 3D.
Step S309, respectively forming a first metal electrode 12 and a second metal electrode 13 on the first transparent conductive layer 10 and the second transparent conductive layer 11, as illustrated by Fig. 3E.

The scope of the present disclosure is defined not by the above-described embodiments, but by the appended claims and their equivalents.

## Claims

1. A manufacturing method of a solar cell, comprising:
providing a silicon substrate of a first conductivity type, and double-side polishing the silicon substrate;
performing a gettering treatment on the silicon substrate, comprising: placing the silicon substrate in a gettering source to form a first silicon doped layer and a first silicon glass layer on a first surface of the silicon substrate and a second silicon doped layer and a second silicon glass layer on a second surface of the silicon substrate opposite to the first surface;
removing the first silicon glass layer;
after the first silicon glass layer is removed, texturing the first surface of the silicon substrate, removing the first silicon doped layer, and simultaneously forming a textured surface on the first surface of the silicon substrate; and
removing at least a part of the second silicon glass layer and the second silicon doped layer.

2. The manufacturing method of a solar cell according to claim 1, wherein,
in a step of removing the second silicon doped layer, only a part of the second silicon doped layer is removed,
preferably, the first silicon dope layer and the second silicon doped layer are of the first conductivity type.

3. The manufacturing method of a solar cell according to claim 2, wherein,
a thickness of the remaining second silicon doped layer after the removing is less than 500nm.

4. The manufacturing method of a solar cell according to any one of claims 1-3, further comprising:
respectively forming a first intrinsic silicon-containing layer and a second intrinsic silicon-containing layer at a side of the first surface and a side of the second surface of the silicon substrate;
respectively forming a first doped silicon-containing layer of a second conductivity type and a second doped silicon-containing layer of a first conductivity type on the first intrinsic silicon-containing layer and the second intrinsic silicon-containing layer, wherein the second conductivity type is different from the first conductivity type; and
respectively forming a first transparent conductive layer and a second transparent conductive layer on the first doped silicon-containing layer and the second doped silicon-containing layer.

5. The manufacturing method of a solar cell according to claim 4, wherein,
the first doped silicon-containing layer of the second conductivity type and the second doped silicon-containing layer of the first conductivity type are a p-doped silicon-containing layer and an n-doped silicon-containing layer, respectively.

6. The manufacturing method of a solar cell according to claim 4, wherein,
the first doped silicon-containing layer of the second conductivity type and the second doped silicon-containing layer of the first conductivity type are an n-type doped silicon-containing layer and a p-type doped silicon-containing layer, respectively.

7. The manufacturing method of a solar cell according to any one of claims 4-6, further comprising:
after texturing the first surface of the silicon substrate and before forming the first intrinsic silicon-containing layer at the side of the first surface of the silicon substrate, rounding the first surface of the silicon substrate.

8. The manufacturing method of a solar cell according to any one of claims 4-6, further comprising:
respectively forming a first transparent conductive layer and a second transparent conductive layer on the first doped silicon-containing layer and the second doped silicon-containing layer; and
respectively forming a first metal electrode and a second metal electrode on the first transparent conductive layer and the second transparent conductive layer.

9. The manufacturing method of a solar cell according to claim 8, wherein,
the first transparent conductive layer is a single layer or a stacked layer made of a material selected from the group consisting of metal oxides doped with a doping element, metal nitrides doped with a doping element, and mixtures thereof,
wherein the doping element comprises at least one selected from the group consisting of indium, tin, calcium, aluminum, cadmium, zinc, cerium and fluorine,
the metal oxides comprise indium oxide, tin oxide, zinc oxide, cadmium oxide, and titanium nitride,
the metal nitrides comprise titanium nitride.

10. The manufacturing method of a solar cell according to claim 8 or 9, wherein,
the second transparent conductive layer is a single layer or a stacked layer made of a material selected from the group consisting of metal oxides doped with a doping element, metal nitrides doped with a doping element, and mixtures thereof,
wherein the doping element comprises at least one selected from the group consisting of indium, tin, calcium, aluminum, cadmium, zinc, cerium and fluorine,
the metal oxides comprise indium oxide, tin oxide, zinc oxide, cadmium oxide, and titanium nitride,
the metal nitrides comprise titanium nitride.

11. The manufacturing method of a solar cell according to any one of claims 8-10, wherein,
a thickness of the first transparent conductive layer is in a range of 1-100 nm, and
a thickness of the second transparent conductive layer is in a range of 1-100 nm.

12. The manufacturing method of a solar cell according to any one of claims 1-11, wherein,
the first intrinsic silicon-containing layer is a single layer or a stacked layer made of a material selected from the group consisting of microcrystalline silicon, nano silicon, amorphous silicon, silicon oxide, silicon carbide and mixtures thereof,
a thickness of the first intrinsic silicon-containing layer is in a range of 1-50nm,
the second intrinsic silicon-containing layer is a single layer or a stacked layer made of a material selected from the group consisting of microcrystalline silicon, nano silicon, amorphous silicon, silicon oxide, silicon carbide and mixtures thereof, and
a thickness of the second intrinsic silicon-containing layer is in a range of 1-50 nm.

13. The manufacturing method of a solar cell according to any one of claims 1-12, wherein,
the first doped silicon-containing layer is a single layer or a stacked layer made of a material selected from the group consisting of microcrystalline silicon, nano silicon, amorphous silicon, silicon oxide, silicon carbide and mixtures thereof,
a thickness of the first doped silicon-containing layer is in a range of 1-50 nm,
the second doped silicon-containing layer is a single layer or a stacked layer made of a material selected from selected from the group consisting of microcrystalline silicon, nano silicon, amorphous silicon, silicon oxide, silicon carbide and mixtures thereof, and
a thickness of the second doped silicon-containing layer ranges from 1-50 nm.
